# EUROPÄISCHE PATENTANMELDUNG

(11) **EP 2 405 730 A2**
(43) Veröffentlichungstag der Anmeldung: **11.01.2012**
(21) Anmeldenummer: 11008081.9
(22) Anmeldetag: 27.08.2010
(51) Int. Cl.: H05K 7/20, G06F 1/20

(54) **Isoliersystem für Rechenzentrum**

(30) Priorität: 28.08.2009 DE 102009039014; 31.08.2009 DE 102009039315; 19.01.2010 DE 102010005141
(62) Teilanmeldung aus: 10773229.9
(71) Anmelder: Hanno-Werk GmbH & Co. KG, 30880 Laatzen (DE)
(72) Erfinder: Hoffmann, Hans J., 31157 Sarstedt (DE); Heidenberger, Dirk, 25482 Appen (DE)
(74) Vertreter: Patentanwälte Thömen & Körner

(57) **Zusammenfassung**

Die Erfindung betrifft ein Isoliersystem für ein Rechenzentrum.

## Beschreibung

Die Erfindung betrifft ein Isoliersystem für ein Rechenzentrum.

Aus der US 6,672,955 B2 ist ein Kühlsystem für ein Rechenzentrum bekannt, bei welchem den in Geräte- und/oder Serverschrankreihen aufgenommenen elektronischen Geräten, insbesondere Servern, Kaltluft aus einem so genannten Kaltgang zugeführt wird. Die Kaltluft, die in einem Wärmetauscher außerhalb des Rechnerraums gekühlt wird, gelangt hierbei mit Hilfe von Gebläsen in einen Doppelboden des Rechnerraums und dann gezielt über vorgegebene bodenseitige Öffnungen in den Kaltgang.

Der Boden eines Rechenzentrums ist meist aufgeständert, um in diesem Leitungen und kalte Luft bzw. Kaltluft zu führen. Im allgemeinen Sprachgebrauch spricht man von einem Doppelboden. Da in diesen Doppelboden Kaltluft eingebracht wird, kann der Doppelboden auch als Druckboden bezeichnet werden.

Ausgehend von diesem Stand der Technik liegt der Erfindung die Aufgabe zugrunde, die im Rechenzentrum vorgesehene Kühlung noch effizienter auszugestalten und insbesondere die Energiekosten im Rechenzentrum deutlich zu senken.

Diese Aufgabe wird erfindungsgemäß durch ein Isoliersystem mit den Merkmalen des Anspruchs 1 gelöst. Weitere vorteilhafte Ausführungsformen ergeben sich aus den Unteransprüchen und der Beschreibung.

Das erfindungsgemäße Isoliersystem für ein Rechenzentrum umfasst einen Rechnerraum mit Geräte- oder Serverschrankreihen, deren Geräte- oder Serverschränke auf einem Doppelboden positioniert sind, wobei bodenseitige Lufteinström- bzw. Lufteinsaugöffnungen, die nicht für die gezielte Zufuhr von Kaltluft vorgesehen sind, erfindungsgemäß mit einem Schaumstoff versehen sind,

Dadurch, dass die nicht für die gezielte Zufuhr von Kaltluft vorgesehenen Lufteinström- bzw. Lufteinsaugöffnungen mit einem Schaumstoff versehen sind, wird auf erstaunlich einfache Weise eine thermische Isolierung des Doppelbodens erreicht, wobei die im Doppelboden geführte Kaltluft im Wesentlichen nur durch die tatsächlich dafür vorgesehenen Öffnungen strömt. Hierzu sind die Lufteinström- bzw. Lufteinsaugöffnungen vorzugsweise möglichst dicht mit dem Schaumstoff verschlossen.

Dadurch wird auf erstaunlich einfache Weise eine erhebliche Energiekosteneinsparung in einem Rechenzentrum erreicht. Der Erfindung liegt dabei die Erkenntnis zugrunde, dass die genannten Lufteinström- bzw. Lufteinsaugöffnungen sowie andere unerwünschte Auslässe im Doppelboden zu einem unerwünschten Kaltluftdruckabfall innerhalb des Doppelbodens eines Rechnerraums führen. Dadurch, dass solche Öffnungen erfindungsgemäß mittels Schaumstoff verschlossen bzw. dicht oder zumindest dichter gemacht sind, kann der gewünschte Kaltluftdruck im Doppelboden mit weniger energetischen Aufwand der Kaltluft erzeugenden Quelle(n) und der den Kaltluftdruck herstellenden Mittel(n) betrieben werden. Es wird auf einfache Weise eine effektive thermische Isolierung des Doppelbodens erreicht, wobei der Schaumstoff gleichzeitig vorteilhaft schallabsorbierend wirkt.

Die Montage des Schaumstoffs in einer Lufteinström- bzw. Lufteinsaugöffnung ist hierbei außerordentlich einfach und kostenfreundlich, wobei der Schaumstoff vorzugsweise ein Weichschaum ist, der insbesondere händisch durch Zusammendrücken in einen komprimierten Zustand bringbar ist und sich nach dem Loslassen wieder ausdehnt bzw. expandiert.

Bei den Lufteinström- bzw. Lufteinsaugöffnungen kann es sich vorzugsweise um solche zur Durchführung diverser Leitungen und/oder Installationsmaterialien, insbesondere solche zur Durchführung von Kabeln, ganz besonders solche zur Durchführung einer Server- und/oder Netzwerkverkabelung, handeln. Insbesondere kann es sich um solche Lufteinström- bzw. Lufteinsaugöffnungen handeln, die bereits im Doppelboden vorhanden sind, aber für die die Durchführung diverser Leitungen und/oder Installationsmaterialien erst später geplant ist.

Ganz allgemein handelt es sich bei den Lufteinström- bzw. Lufteinsaugöffnungen um solche, die zu unerwünschten Druckverlusten im Doppelboden führen. Dabei können diese Lufteinström- bzw. Lufteinsaugöffnungen geplant in den Doppelboden eingebracht sein oder ungewollt.

Vorzugsweise werden solche Lufteinström- bzw. Lufteinsaugöffnungen mit Schaumstoff versehen, die in den, den Doppelboden bildenden Platten, insbesondere als Lochausschnitt, oder angrenzend an die, den Doppelboden bildenden Platten, insbesondere als Ausschnitt im Randbereich oder durch Fehlen einer oder mehrerer Platten im Randbereich, angeordnet sind.

Eine Weiterbildung der Erfindung sieht vor, dass der Schaumstoff kugel-, kissen-, vorzugsweise jedoch plattenförmig ausgebildet ist.

Um den Schaumstoff auf einfachste Weise der Form der Lufteinström- bzw. Lufteinsaugöffnung anzupassen und vorhandene Leitungen zu umschließen, kann es vorteilhaft sein, wenn der Schaumstoff vorzugsweise in einzelne Rechtecke, besonders bevorzugt in einzelne Quadrate, vorgestanzt bzw. perforiert ist. Diese können entnommen, wiedereingesetzt oder zur Aufnahme einer oder mehrer Leitungen und/oder Installationsmaterialien kurzfristig voneinander getrennt werden. Der Ausgangsschaumstoff hat vorzugsweise Abmessungen von 620 mm x 620 mm x 50 mm. Mit einem solchen Schaumstoff lassen sich üblicherweise alle in einem Rechnerraum unerwünschten Lufteinström- bzw. Lufteinsaugöffnung verschließen. Kleinere Abmessungen oder andere Formen können durch einfaches Teilen entlang der Perforierungen bzw. Vorstanzungen des Schaumstoffs hergestellt werden.

Die Lufteinström- bzw. Lufteinsaugöffnung können unterschiedlichste Formen haben. Sie können beispielsweise rund oder ecklg ausgebildet sein.

Eine Weiterbildung der Erfindung sieht vor, dass der Schaumstoff schwer- oder nicht entflammbar ist.

Um eine hohe Dichtigkeit und Schallabsorption zu erhalten, kann es von Vorteil sein, wenn der Schaumstoff ein Melaminharzschaum ist. Melaminharzschaum ist ein flexibler, offenzelliger und sehr leichter Weichschaumstoff. Er besitzt eine hohe Schallabsorption und ist temperaturbeständig. Aufgrund der feinzelligen Struktur besitzt Melaminharzschaum bei Normaltemperatur eine relativ geringe Wärmeleitfähigkeit, so dass die im Doppelboden geführte Kaltluft nicht erwärmt wird. Melaminharzschaum eignet sich somit besonders zur thermischen Isolierung. Vorteilhaft ist zudem, dass Melaminharzschaum die Baustoffklasse B1 erfüllt und nur schwer entflammbar ist.

Für bestimmte Anwendungsfälle kann es von Vorteil sein, wenn der Schaumstoff ein EPS Polystyrolpartikelschaum ist. Für gewisse Anwendungsfälle kann es von Vorteil sein, wenn der Schaumstoff ein XPS Polystyrolextruderschaum ist. Für andere gewisse Anwendungsfälle kann es von Vorteil sein, wenn der Schaumstoff ein PUR Hart-oder Weichschaum ist. Für andere bestimmte Anwendungsfälle kann es von Vorteil sein, wenn der Schaumstoff ein EPE, ein EPP oder ein EPO Polyolefinschaum ist. Für noch andere bestimmte Anwendungsfälle kann es von Vorteil sein, wenn der Schaumstoff ein PES Polyesterschaum ist. Für noch andere gewisse Anwendungsfälle kann es von Vorteil sein, wenn der Schaumstoff ein PF Phenolharzschaum. Für wieder andere bestimmte Anwendungsfälle kann es von Vorteil sein, wenn der Schaumstoff ein UF Harnstoff-Formaldehydschaum ist. Für wieder andere gewisse Anwendungsfälle kann es von Vorteil sein, wenn der Schaumstoff ein PET Polyethylenterephthalatschaum. Besonders vorteilhaft kann es sein, wenn der Schaumstoff ein Melaminharzschaum ist.

Für bestimmte Einsatzzwecke kann es von Vorteil sein, wenn der Schaumstoff ein Zellkautschuk, vorzugsweise NBR, EPDM, NBS oder CR, ist. Für gewisse Einsatzzwecke kann es von Vorteil sein, wenn der Schaumstoff ein Zellgummi, vorzugsweise ein Moosgummi, ist. Für andere bestimmte Einsatzzwecke kann es von Vorteil sein, wenn der Schaumstoff ein PVC Zellkunststoff ist. Für andere gewisse Einsatzzwecke kann es von Vorteil sein, wenn der Schaumstoff eine ML Mehrschicht-Leichtbauplatte ist. Für wieder andere bestimmte Einsatzzwecke kann es von Vorteil sein, wenn der Schaumstoff eine HWL Holzwolle-Leichtbauplatte ist.

Für bestimmte Gebrauchsfälle kann es von Vorteil sein, wenn der Schaumstoff ein imprägnierter Kunstschaumstoff, vorzugsweise ein Acrylat imprägnierter PUR-Schaumstoff, ist.

Für gewisse Gebrauchsfälle kann es von Vorteil sein, wenn der Schaumstoff Mineral-Glas-Keramikwolle ist oder aufweist. Für andere gewisse Gebrauchsfälle kann es von Vorteil sein, wenn der Schaumstoff ein Schaum- oder Blähglas ist oder aufweist. Für andere bestimmte Gebrauchsfälle kann es von Vorteil sein, wenn der Schaumstoff Perlit oder Blähperlit, Silikat, Blähglimmer- oder Blähton, oder Bims ist oder aufweist.

Für bestimmte Verwendungsfälle kann es von Vorteil sein, wenn der Schaumstoff ein Vlies, vorzugsweise aus Kunst-, Natur- und/oder Mineralfasern, ist. Für gewisse Verwendungsfälle kann es von Vorteil sein, wenn der Schaumstoff ein Filz, vorzugsweise aus Kunst-, Natur- und/oder Mineralfasern, ist. Für andere bestimmte Verwendungsfälle kann es von Vorteil sein, wenn der Schaumstoff wenigstens eine Metallfolie, vorzugsweise eine Aluminiumfolie, ist oder aufweist. Für wieder andere bestimmte Verwendungsfälle kann es von Vorteil sein, wenn der Schaumstoff wenigstens eine Kunststofffolie ist oder aufweist. Für noch andere bestimmte Verwendungsfälle kann es von Vorteil sein, wenn der Schaumstoff eine Bitumenbeschichtung aufweist.

Schränke werden meist einheitlich so bestückt, dass die Gerätefronten auf einer Seite des Schrankes angeordnet sind. Dadurch soll erreicht werden, dass die Geräte einheitlich auf einer Seite die zur Kühlung bestimmte Kaltluft ansaugen und die erwärmte Luft einheitlich auf einer anderen, üblicherweise gegenüberliegenden Seite wieder abgeben.

Es kann vorteilhaft sein, wenn Öffnungen der Front- und Rückseite, aber auch der linken und/oder rechten Seitenteile sowie des Daches einer teilweise leeren bzw. vollständig leeren, also mit einem kleineren elektronischen Gerät bzw. ohne elektronischem Gerät versehenen Aufnahme eines Geräte- oder Serverschrankes, mit dem Schaumstoff versehen sind. Die mit Schaumstoff vorzugsweise möglichst dicht zu machenden Öffnungen dienen hierbei nicht der gezielten Durchführung von Kaltluft durch den Geräte- oder Serverschrank. Dadurch werden Klimaverluste durch beispielsweise unerwünschte Vermischungen oder Verwirbelungen von warmer und kalter Luft im Geräte- oder Serverschrank vermieden. Der Geräte- oder Serverschrank kann so auf einfache, insbesondere montagefreundliche Weise, thermisch isoliert werden. Insgesamt wird die erforderliche Kühlung noch effizienter ausgestaltet. Der Schaumstoff lässt sich hierbei äußerst flexibel den Gegebenheiten anpassen.

Für einige Anwendungsfälle kann es von Vorteil sein, wenn die Oberfläche des Schaumstoffs verdichtet ist. Für einige Einsatzfälle kann es von Vorteil sein, wenn die Oberfläche des Schaumstoffs für sich oder zusätzlich geprägt ist. Für einige weitere Einsatzfälle kann es von Vorteil sein, wenn die Oberfläche des Schaumstoffs für sich oder zusätzlich imprägniert ist. Für einige andere Einsatzfälle kann es von Vorteil sein, wenn die Oberfläche des Schaumstoffs für sich oder zusätzlich beschichtet ist, wobei die Beschichtung vorzugsweise eine Kunststoffbeschichtung und/oder besonders bevorzugt eine Brandschutzbeschlchtung Ist oder aufwelst.

Es kann vorteilhaft sein, wenn der Schaumstoff eine glatte oder vorzugsweise eine geprägte Oberflächenverdichtung aufweist. Dadurch wird insbesondere eine verbesserte thermische Isolierung und Dichtheit erreicht.

## Patentansprüche

1. Isoliersystem für ein Rechenzentrum, umfassend einen Rechnerraum mit Geräte- oder Serverschrankreihen, die Geräte- oder Serverschränke aufweisen, **dadurch gekennzeichnet, dass** Öffnungen der Front- und Rückseite, aber auch der linken und/oder rechten Seitenteile sowie des Daches eines leeren bzw. tellweise leeren, also nicht mit einem elektronischen Gerät bzw. mit einem kleineren elektronischen Gerät versehenen Faches des Aufnahmerahmens eines Geräte- oder Serverschrankes, mit einem Schaumstoff versehen sind.

2. Isoliersystem nach Anspruch 1, **dadurch gekennzelchnet,** dass die Geräte-oder Serverschränke auf einem Doppelboden positioniert sind, wobei bodenseitige Lufteinström- bzw. Luftelnsaugöffnungen, die nicht für die gezlelte Zufuhr von Kaltluft vorgesehen sind, mit einem Schaumstoff versehen sind.

3. Isoliersystem nach Anspruch 2, **dadurch gekennzeichnet, dass** die Lufteinström- bzw. Lufteinsaugöffnungen solche zur Durchführung diverser Leitungen und/oder Installationsmaterialen, insbesondere solche zur Durchführung von Kabeln, ganz besonders solche zur Durchführung einer Server- und/oder Netzwerkverkabelung, sind.

4. Isoliersystem nach einem der Ansprüche 1 bis 3, **dadurch gekennzeichnet, dass** der Schaumstoff kugel-, kissen-, vorzugsweise jedoch plattenförmig ausgebildet ist.

5. Isoliersystem nach einem der Ansprüche 1 bis 4, **dadurch gekennzeichnet, dass** der Schaumstoff vorgestanzt bzw. perforiert ist, wobei der Schaumstoff vorzugsweise in einzelne Rechtecke, vorzugsweise Quadrate, vorgestanzt bzw. perforiert ist.

6. Isoliersystem nach einem der Ansprüche 1 bis 5, **dadurch gekennzeichnet, dass** der Schaumstoff schwer- oder nicht entflammbar ist.

7. Isoliersystem nach einem der Ansprüche 1 bis 6, **dadurch gekennzeichnet, dass** der Schaumstoff ein Weichschaum ist.

8. Isoliersystem nach einem der Ansprüche 1 bis 7, **dadurch gekennzeichnet, dass** der Schaumstoff ein EPS Polystyrolpartikelschaum, ein XPS Polystyrolextruderschaum, ein PUR Hart- oder Weichschaum, eine EPE, ein EPP oder EPO Polyolefinschaum, ein PES Polyesterschaum, ein PF Phenolharzschaum, ein UF Harnstoff-Formaldehydschaum, ein PET Polyethylenterephthalatschaum oder vorzugsweise ein Melaminharzschaum ist.

9. Isoliersystem nach einem der Ansprüche 1 bis 8, **dadurch gekennzeichnet, dass** der Schaumstoff ein Zellkautschuk, vorzugsweise NBR, EPDM, NBS oder CR, ein Zellgummi, vorzugsweise Moosgummi, ein PVC Zellkunststoff, eine ML Mehrschicht-Leichtbauplatte oder eine HWL Holzwolle-Leichtbauplatte ist.

10. Isoliersystem nach einem der Ansprüche 1 bis 9, **dadurch gekennzeichnet, dass** der Schaumstoff ein imprägnierter Kunstschaumstoff, vorzugsweise ein Acrylatimprägnierter PUR-Schaumstoff, ist.

11. Isoliersystem nach einem der Ansprüche 1 bis 10, **dadurch gekennzelchnet,** dass der Schaumstoff Mineral-Glas-Keramikwolle, Schaum- oder Blähglas, Perlit oder Blähperlit, Silikat, Blähglimmer- oder Blähton, oder Bims ist oder aufweist.

12. Isoliersystem nach einem der Ansprüche 1 bis 11, **dadurch gekennzeichnet, dass** der Schaumstoff ein Vlies, vorzugsweise aus Kunst-, Natur- und/oder Mineralfasern, ein Filz, vorzugsweise aus Kunst-, Natur- und/oder Mineralfasern, wenigstens eine Metallfolie, vorzugsweise eine Aluminiumfolie oder wenigstens eine Kunststofffolie ist oder aufweist.

13. Isoliersystem nach einem der Ansprüche 1 bis 12, **dadurch gekennzeichnet, dass** der Schaumstoff eine Bitumenbeschichtung aufweist.

14. Isoliersystem nach einem der Ansprüche 1 bis 13, **dadurch gekennzeichnet, dass** die Oberfläche des Schaumstoffs verdichet, geprägt, imprägniert und/oder beschichtet ist, wobei die Beschichtung vorzugsweise eine Kunststoffbeschichtung und/oder besonders bevorzugt eine Brandschutzbeschichtung ist.

15. Isoliersystem nach einem der Ansprüche 1 bis 14, **dadurch gekennzeichnet, dass** der Schaumstoff eine glatte oder vorzugsweise eine geprägte Oberflächenverdichtung aufweist.
